# EUROPEAN PATENT APPLICATION

(11) **EP 1 283 548 A1**
(43) Date of publication of application: **12.02.2003**
(21) Application number: 01271656.9
(22) Date of filing: 28.11.2001
(51) Int. Cl.: H01L 21/60

(54) **SEALING RESIN FOR FLIP-FLOP MOUNTING**

(30) Priority: 21.12.2000 JP 2000388087
(71) Applicant: Sony Corporation, Tokyo 141-0001 (JP)
(72) Inventor: MORISHIMA, Masayuki, 8-4 Shiomi, Kisarazu-shi, Chiba 292-0834 (JP); IWABUCHI, Kaoru c/o SONY CORP.,, Tokyo 141-0001 (JP); NAKADA, Masakazu c/o SONY EMCS CORP. KOHDA TEC, Nukata-gun, Aichi 444-0194 (JP)
(74) Representative: Müller, Frithjof E., Dipl.-Ing.
(86) International application number: JP0110396
(87) International publication number: WO02050892

(57) **Abstract**

A sealing resin for flip chip mounting. It permits a semiconductor chip to be mounted on a printed circuit board with high reliability. It contributes to high productivity and cost reduction in flip chip mounting. When in use for flip chip mounting, it fills the gap between a semiconductor chip and a printed circuit board, thereby sealing solder connections between them. It comprises an epoxy resin, an acid anhydride hardener to cure said epoxy resin, a flux to remove oxide film from solder bumps or solder balls on the semiconductor chip and printed circuit board, and an inorganic particulate filler with an average diameter ranging from 10 µm to 20 µm.

## Description

### Technical Field

The present invention relates to a sealing resin for flip chip mounting. At the time of mounting a semiconductor chip on a printed circuit board by flip chip mounting method, the sealing resin fills the gap between them to seal their solder connections. More particularly, the present invention relates to a sealing resin for flip chip mounting by the C4 (controlled collapse chip connection) process through soldering. This sealing resin permits flip chip mounting which ensures reliability even when a semiconductor chips with closely spaced solder bumps is mounted on a printed circuit board.

### Background Art

There are several methods for mounting a semiconductor chip on a printed circuit board. Flip chip mounting method is attracting attention because of its capability for high-density mounting of multiple-pin semiconductor chips.

The flip chip mounting method is one for solder-bonding a semiconductor chip (with its face down) directly to solder bumps or solder lands on the wiring pattern of a printed circuit board. Typical of lead connection by flip chip mounting is the C4 (controlled collapse chip connection) process that employs solder bonding.

Flip chip mounting by the C4 process employs a sealing resin which fills the gap between a semiconductor chip and a printed circuit board to seal solder connections. The sealing resin is intended to isolate and protect from external environment solder connections between a semiconductor chip and a printed circuit board. It is also intended to protect solder connections from thermal stress due to difference in linear expansion coefficient between a semiconductor chip and a printed circuit board.

There are two major methods which are widely used in the C4 process to fill the gap between a semiconductor chip and a printed circuit board with the sealing resin for flip chip mounting. They are called "capillary flow method" and "compression flow method".

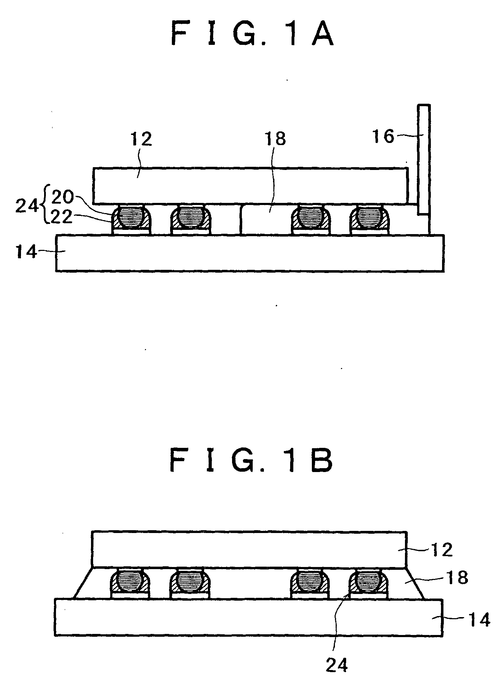

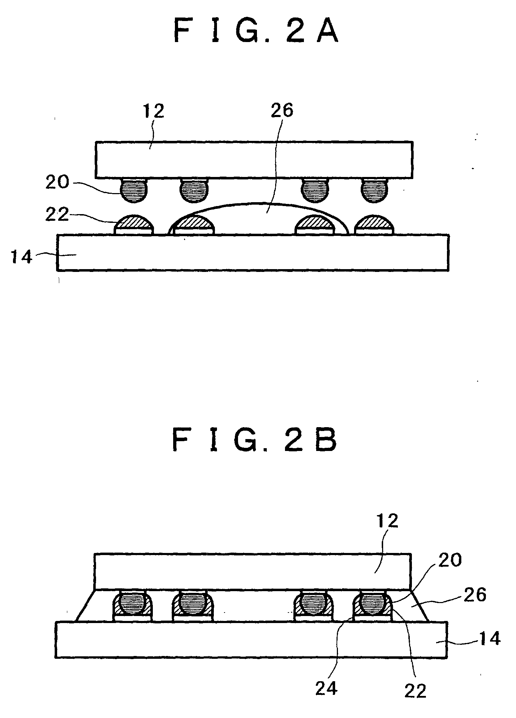

Usage of the sealing resin in the capillary flow method and the compression flow method will be described with reference to Figs. 1A and 1B and Figs. 2A and 2B, respectively, in which a semiconductor chip and a printed circuit board are shown in section for each step.

The capillary flow method shown in Fig. 1A consists of a step of positioning a semiconductor chip 12 on a printed circuit board 14, a step of removing oxide film from solder bumps and solder balls by means of flux (not shown), a step of bonding together the semiconductor chip 12 and the printed circuit board 14 by reflow, and a step of injecting a thermosetting resin 18 as a sealing resin (by using a dispenser 16 or the like) from the side of the semiconductor chip 12.

In Fig. 1A, the reference numeral 20 denotes high-melting solder bumps (including solder balls) formed on the leads of the semiconductor chip 12, the reference numeral 22 denotes low-melting solder bumps formed on solder lands of wiring pattern of the printed circuit board 14, and the reference numeral 24 denotes the thus formed solder connections.

The injected thermosetting resin 18 fills the gap between the semiconductor chip 12 and the printed circuit board 14 by capillary action. Subsequently, the thermosetting resin 18 is cured by heating. As shown in Fig. 1B, the cured thermosetting resin 18 seals solder connections formed in the gap between the semiconductor chip 12 and the printed circuit board 14. Therefore, the sealing resin used in this method contains no flux.

Unfortunately, the thermosetting resin 18 used for the capillary flow method suffers the disadvantage of taking a long time in its injecting operation. In other words, the capillary flow method requires several steps before injection and heat-curing of the thermosetting resin 18. Such steps include removing oxide film from solder bumps by means of flux prior to reflow, causing solder bumps to reflow in the reflow oven, and thoroughly cleaning the printed circuit board 14 contaminated with flux. These additional steps reduce productivity.

One way to improve productivity is the compression flow method which has been developed recently. This method employs a flux-containing thermosetting resin as the sealing resin for flip chip mounting.

One example of the sealing resin for flip chip mounting used in the compression flow method is disclosed in Japanese Patent Laid-open No. 280443/1992. It contains malic acid as a flux.

As shown in Fig. 2A, the compression flow method consists of a step of applying a flux-containing thermosetting resin 26 to the printed circuit board, a step of positioning the semiconductor chip 12 under pressure on the printed circuit board 14 (such that the semiconductor chip 12 spreads the layer of the thermosetting resin 26), a step of placing the semiconductor chip 12 and the printed circuit board 14 in a reflow oven, a step of reflowing the solder (in which the flux in the thermosetting resin 26 removes oxide film from the solder bumps and solder balls), and a step of curing the thermosetting resin 26 which has filled the gap between the semiconductor chip 12 and the printed circuit board 14.

The result of the above-mentioned steps is shown in Fig. 2B. It should be noted that the solder bumps 20 of the semiconductor chip 12 are joined to the solder bumps 22 of the printed circuit board 14. Thus the solder connections 24 are formed. At the same time, the gap between the semiconductor chip 12 and the printed circuit board 14 is filled with the sealing thermosetting resin 26, and the solder connections 24 are sealed.

The recent technical trend toward semiconductor chips with smaller size and higher performance requires that semiconductor chips have more closely spaced solder bumps with reduced dimensions.

On the other hand, the reliability of electrical and mechanical bonding between the semiconductor chip and the printed circuit board depends on the bonding between solder bumps or the bond strength of solder connections. In other words, it depends on the characteristic properties of the thermosetting resin reinforcing the bump-to-bump bonding.

The thermosetting resin with a large linear expansion coefficient expands unevenly between the semiconductor chip and the printed circuit board, thereby generating thermal stresses which would damage the solder connections.

One way to protect the solder connections from damage by thermal effect is to reduce the linear thermal expansion coefficient of the thermosetting resin by incorporation with a filler. This has been regarded as important for improvement of the characteristic properties of the thermosetting resin.

However, the conventional sealing resin for flip chip mounting is not satisfactory as far as the expansion coefficient is concerned. For example, the one used for compression flow method has a large linear expansion coefficient because it contains no filler. Consequently, it generates stresses that concentrate on connections between bumps, thereby damaging electrical and mechanical bonding and deteriorating the reliability of connections.

Incidentally, the conventional sealing resin for flip chip mounting by capillary flow method has problems with incorporation with a filler as mentioned in the following.

The first problem involved with the sealing resin for capillary flow method is that the sealing resin does not fill the gap completely because the filler contained therein is caught by solder bumps. One way to avoid this problem is to use a filler in the form of fine particles smaller than 10 µm in diameter. This filler is not caught by closely spaced solder bumps. However, this filler raises the cost of the sealing resin and in turn raises the cost of flip chip mounting.

Moreover, incorporation with a filler raises the viscosity of the thermosetting resin. High viscosity reduces the filling speed of the sealing resin for capillary flow method, which leads to inefficient filling operation.

Now, it is an object of the present invention to provide a sealing resin for flip chip mounting which ensures reliability even when a semiconductor chips with closely spaced solder bumps is mounted on a printed circuit board and which reduces assembling cost and improves productivity.

### Disclosure of the Invention

The present invention originated from the present inventors' idea that compression flow method is more useful than capillary flow method for reduction of assembling cost and improvement of productivity and that the reliability of mounting will be increased if the sealing resin is incorporated with a filler so as to reduce its linear expansion coefficient. Thus, the present inventors tried to develop a filler-containing sealing resin for compression flow method.

Several samples of sealing resins for flip chip mounting by compression flow method were prepared. Each sealing resin contains a filler varying in particle diameter. Experiments with these samples were carried out to bond a semiconductor chip to a printed circuit board. Solder connections sealed with the sealing resin were examined for nondefective fraction (defined later).

The semiconductor chip used for the experiment has high-melting solder bumps composed of Pb (96 mass%) and Sn (4 mass%). The printed circuit board used for the experiment has low-melting solder bumps composed of Pb (37 mass%) and Sn (63 mass%).

The sealing resin for flip chip mounting used for the experiment is composed of 100 parts by mass of thermosetting resin (whose composition is shown in Table 1) and 20 parts by mass of filler (silica particles) varying in average diameter (2, 5, 10, 15, and 20 µm).

**Table 1**

| Components | Composition |
|---|---|
| Epoxy resin (glycidyl ether type) | 50 mass% |
| Hardener (acid anhydride) | 40 mass% |
| Flux (carboxylic acid) | 10 mass% |

The experiment was carried out in the following manner. First, the above-mentioned sealing resin is applied to the printed circuit board by using a dispenser. Then, the semiconductor chip is positioned on the printed circuit board. Finally, the assembly is heated to a temperature higher than the melting point of the low-melting solder, so that the solder bumps on the printed circuit board reflow.

The actual procedure is as follows. The assembly of a printed circuit board and a properly positioned semiconductor chip is placed on a hot plate heated to 200°C. The assembly is kept at this temperature for about 90 seconds so that the low-melting solder bumps reflow (which bonds the semiconductor chip to the printed circuit board) and the sealing resin is cured.

After sealing, each bump joint between the semiconductor chip and the printed circuit board was tested for continuity. The ratio of good bump joints to total bump joints was calculated. The result is defined as the nondefective fraction. For example, a nondefective fraction of 70% means that defective bump joints with poor continuity account for 30% in the total bump joints.

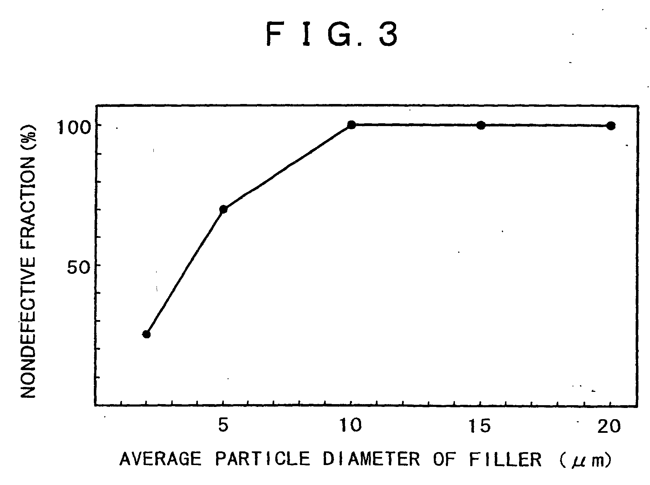

The results of the experiment are shown in Fig. 3. It is noted that the nondefective fraction increases in proportion to the average diameter of filler particles and it reaches 100% for fillers having an average particle diameter larger than 10 µm. It was also found that fillers with an average particle diameter larger than 20 µm prevent the sealing resin from uniform flowing and decrease the nondefective fraction.

The same tendency as above was noticed when the filler content was increased from 10 parts by mass to 70 parts by mass in the samples of sealing resins.

Experiments were also carried out with sealing resins for flip chip mounting which vary in the formulation of epoxy resin, hardener, and flux. The results of the experiments indicate that the nondefective fraction is 100% so long as the filler has an average particle diameter ranging from 10 µm to 20 µm.

The results of the above-mentioned experiments indicate that the flux-containing sealing resin gives good solder connections when applied to closely spaced bumps so long as it contains a filler whose average particle diameter ranges from 10 µm to 20 µm.

The present invention, which was completed to achieve its object on the basis of the above-mentioned findings, is directed to a sealing resin to fill the gap between a semiconductor chip and a printed circuit board, thereby sealing solder connections between them at the time of flip chip mounting, said sealing resin comprising an epoxy resin, an acid anhydride hardener to cure said epoxy resin, a flux to remove oxide film from solder bumps or solder balls on the semiconductor chip and printed circuit board, and an inorganic particulate filler with an average diameter ranging from 10 µm to 20 µm.

According to the present invention, the flux is a carboxylic acid such as malic acid and the ratio of the flux in the resin composition excluding the filler ranges from 1 mass% to 20 mass%.

Moreover, according to the present invention, the adequate ratio of the filler in the resin composition ranges from 10 parts by mass to 70 parts by mass for 100 parts by mass of the total quantity of epoxy resin, hardener, and flux. The hardener is added in an amount necessary to cure the epoxy resin.

The inorganic particulate filler used in the present invention includes, for example, silica.

The sealing resin for flip chip mounting which is covered by the present invention is suitable for compression flow method which is intended to fill the gap between a semiconductor chip and a printed circuit board with the sealing resin, thereby sealing solder connections between them.

### Brief Description of the Drawings

Figs. 1A and 1B are sectional views illustrating the steps of jointing together a semiconductor chip and a printed circuit board by capillary flow method with a seal-ing resin.
Figs. 2A and 2B are sectional views illustrating the steps of jointing together a semiconductor chip and a printed circuit board by compression flow method with a sealing resin.
Fig. 3 is a graph showing the relation between the average diameter of filler and the nondefective fraction.

### Best Mode for Carrying out the Invention

The invention will be described in more detail with reference to the following example.

### Example

This example demonstrates a sealing resin for flip chip mounting which is covered by the present invention.

The sealing resin in this example is composed of 100 parts by mass of the flux-containing thermosetting resin (whose components and composition are shown in Table 1 above) and 20 parts by mass of silica particles (as a filler) having an average diameter of 10 µm.

The sealing resin in this example was used to join together a semiconductor chip and a printed circuit board by compression flow method in the same way as in the above-mentioned experiment. The resulting samples were examined for nondefective fraction and reliability.

It was found that the sealing resin in this example achieved 100% nondefective fraction when used for flip chip mounting under the same condition as the above-mentioned experiment.

For reliability examination, the assembled samples underwent temperature cycle test at -25°C to +125°C. The solder connections between the semiconductor chip and the printed circuit board retained good electrical continuity and mechanical bonding even after 1000 cycles when they were sealed with the sealing resin of this example.

The assembled samples also underwent insulation deterioration test with voltage application (5V) in an atmosphere of 85°C and 85 %RH. It was found that the samples remained stable even after 2000 hours.

The results of the above-mentioned examinations for connection and reliability indicate that the sealing resin for flip chip mounting in this example provides good bonding of solder bumps and ensures high reliability for mechanical strength and electrical continuity.

### Exploitation in Industry

The present invention demonstrated that it is possible to achieve a high nondefective fraction for semiconductor chips which have closely spaced solder bumps to meet requirements for size reduction and high performance, if the sealing resin for flip chip mounting is used which is composed of a flux-containing thermosetting resin and a filler with an average particle diameter ranging from 10 µm to 20 µm.

The sealing resin of the present invention provides high reliability for flip chip mounting.

When used for mounting semiconductor chips, the sealing resin of the present invention can be applied to compression flow method, which is independent of resin viscosity. Therefore, the present invention contributes to high productivity and cost reduction in flip chip mounting.

## Claims

1. A sealing resin to fill the gap between a semiconductor chip and a printed circuit board, thereby sealing solder connections between them at the time of flip chip mounting, said sealing resin comprising an epoxy resin, an acid anhydride hardener to cure said epoxy resin, a flux to remove oxide film from solder bumps or solder balls on the semiconductor chip and printed circuit board, and an inorganic particulate filler with an average diameter ranging from 10 µm to 20 µm.

2. The sealing resin for flip chip mounting as defined in Claim 1, which contains the inorganic particulate filler in an amount ranging from 10 parts by mass to 70 parts by mass for 100 parts by mass of the total quantity of epoxy resin, hardener, and flux.

3. The sealing resin for flip chip mounting as defined in Claim 1 or 2, which is designed to fill the gap between a semiconductor chip and a printed circuit board by compression flow method for sealing solder connections.
